# EUROPÄISCHE PATENTSCHRIFT

(11) **EP 2 618 429 B1**
(45) Veröffentlichungstag und Bekanntmachung des Hinweises auf die Patenterteilung: **08.08.2018**
(21) Anmeldenummer: 12305061.9
(22) Anmeldetag: 17.01.2012
(51) Int. Cl.: H01R 12/62, H01R 43/02, H01R 4/02

(54) **Schutzelement für Leiter**
Protection element for conductors
Elément de protection pour conducteurs

(43) Veröffentlichungstag der Anmeldung: 24.07.2013
(73) Patentinhaber: Nexans, 92400 Courbevoie (FR)
(72) Erfinder: Riedel, Richard, 92685 Floß (DE); Völkl, Dietmar, 95703 Plössberg (DE); Bock, Norbert, 95478 Kemnath (DE); Wagner, Johannes, 92685 Floss (DE)
(74) Vertreter: Lenne, Laurence

(56) Entgegenhaltungen:
- EP-A1- 1 195 853
- US-A- 5 049 090
- US-A- 5 772 467

## Beschreibung

Die vorliegende Erfindung betrifft einen Träger mit einem Schutzelement für elektrische Leiter gemäß dem Oberbegriff des Patentanspruchs 1.

### Stand der Technik

Zur Herstellung einer Verbindung von Leitern mit Kontakten einer Platine werden die Leiter in Ausnehmungen eines Trägers gesteckt, parallel zu den Kontakten positioniert, während der Träger mit der Platine verrastet ist, und anschließend mit den Kontakten verschweißt. An dem bekannten Träger und dem Verfahren zur Herstellung einer Verbindung zwischen den Leitern und den Kontakten ist nachteilig, dass eine manuelle Ausrichtung der Leiter zu den Kontakten der Platine erforderlich ist. Weiterhin ist an dem bekannten Verfahren nachteilig, dass die Kontakte, die den Träger überragen, auch bei geringfügiger mechanischer Belastung während eines Transportvorgangs aus der Position gebogen werden, die für eine Kontaktierung erforderlich ist.

Die US 5,049,090 A beschreibt eine Klemmvorrichtung für abisolierte Adern, um diese gegen Kontakte einer Platine zu klemmen. In der Druckschrift wird dargestellt, dass ein Leiter mit einem endständigen Abschnitt von Isoliermaterial an einem Abstandshalter angeordnet werden kann. Dabei wird der abisolierte Leiter um den Abstandshalter gebogen. Aneinander angelenkte Teile weist diese Vorrichtung nicht auf.

Die EP 0195853 A1 beschreibt ein Verbindungsteil für Kabel mit einem platinenseitigen Teil und einem mit diesem verrastbaren kabelseitigen Teil. Das kabelseitige Teil weist Bohrungen für darin anzuordnende Kabel auf und ein schwenkbares Klemmelement, das gegen die Kabel geschwenkt werden kann, die die Bohrungen überragen.

Die US 5,772,467 A beschreibt eine Halterung für Kabelenden, bei der ein Rahmen eine Reihe von Bohrungen bildet, in denen Kabel angeordnet werden können. Dieser Rahmen ist mittels eines Scharniers in einem Gehäuseteil angelenkt, sodass Durchtrittsbohrungen des Gehäuseteils fluchtend zu den Bohrungen des Rahmens ausgerichtet werden können und zu diesen verschwenkbar sind. Beim Verschwenken des Rahmens, in dessen Bohrungen Kabel angeordnet sind, gegen das Gehäuse werden die Kabel abschnittsweise gegen einen federnden Vorsprung belastet, der die Kabel über die Vorrichtung hinausdrückt. In diesem hinausgedrückten Bereich können die Kabel dann gegen Kontakte auf einer Platine angeordnet werden. Die Vorrichtung weist immer den Rahmen und das Gehäuse auf, um die Kabel gegen Kontakte zu pressen.

### Aufgabe der Erfindung

Der Erfindung liegt die Aufgabe zurunde, eine Vorrichtung und ein Verfahren bereitzustellen, um die Herstellung der Kontaktierung zwischen Leitern, die über Ausnehmungen eines Trägers ragen, mit Kontakten einer Platine zu verbessern, insbesondere die Ausrichtung der den Träger überragenden Abschnitte der Leiter zu den an der Platine festgelegten Kontakten zu verbessern.

Diese Aufgabe wird entsprechend der kennzeichnenden Merkmale von Anspruch 1 und Anspruch 2 gelöst.

### Allgemeine Beschreibung der Erfindung

Das Schutzelement weist Ausnehmungen auf, die zur Anordnung jeweils eines Leiters eingerichtet sind, wobei das Schutzelement angrenzend an den Träger angeordnet wird und insbesondere die Ausnehmungen des Schutzelements in einer ersten Stellung fluchtend mit den Ausnehmungen des Trägers und in einer zweiten Stellung in einem Winkel zu den Ausnehmungen des Trägers angeordnet sind. Das Schutzelement weist einen Scharnieranteil auf, der eingerichtet ist, mit einem passenden Scharnieranteil des gegen das Schutzelement anordenbaren Trägers zusammen zu wirken, wobei ein Verschwenken des Schutzelements gegen den Träger um die Schwenkachse der zusammen wirkenden Scharnieranteile das Schutzelement am Träger von der ersten Stellung in die zweite Stellung führt. Zumindest zwei Ausnehmungen des Schutzelements, vorzugsweise alle Ausnehmungen des Schutzelements, die zur Aufnahme von Leitern vorgesehen sind, sind in einer Ebene angeordnet, zu der die Schwenkachse des Scharnieranteils parallel ist, bzw. parallel zu der Schwenkachse des Scharniers aus den Scharnieranteilen des Schutzelements und des Trägers.

Das Schutzelement weist einen ersten Anschlag auf, der eingerichtet ist, bei Kontaktierung des Trägers die Verschwenkung des Schutzelements in die erste Stellung zu begrenzen und einen zweiten Anschlag, der eingerichtet ist, nach Verschwenken des Schutzelements in die zweite Stellung den Träger zu kontaktieren. Auf diese Weise begrenzen erster und zweiter Anschlag die Verschwenkung des Schutzelements gegen den Träger in die erste bzw. in die zweite Stellung. Der Träger weist einen dem ersten Anschlag des Schutzelements gegenüberliegenden ersten Anschlag auf und einen dem zweiten Anschlag des Schutzelements gegenüberliegenden zweiten Anschlag, die eingerichtet sind, beim Verschwenken jeweils vom ersten bzw. zweiten Anschlag des Schutzelements kontaktiert zu werden.

Das Schutzelement liegt in Kombination mit dem Träger vor, wobei die Scharnieranteile des Schutzelements die Scharnieranteile des Trägers kontaktieren und das Schutzelement in eine erste Stellung zum Träger positionierbar ist, in der die Ausnehmungen des Schutzelements fluchtend mit den Ausnehmungen des Trägers ausgerichtet sind, wobei der erste Anschlag des Schutzelements gegen den ersten Anschlag des Trägers angeordnet ist. Die Schwenkachse des Scharniers ist parallel zu der Ebene angeordnet, in der zumindest zwei Ausnehmungen des Schutzelements und/oder zumindest zwei Ausnehmungen des Trägers angeordnet sind, in welche jeweils ein Leiter anzuordnen ist. In der zweiten Stellung, die durch Verschwenken des Schutzelements gegen den Träger um die Schwenkachse eingenommen wird, sind die Ausnehmungen des Schutzelements in einem Winkel zu den Ausnehmungen des Trägers angeordnet, beispielsweise in einem Winkel von 70° -120°, bevorzugt in einem Winkel von 90°. In der zweiten Stellung liegt der zweite Anschlag des Schutzelements gegen den zweiten Anschlag des Trägers an, um die Verschwenkung auf die zu begrenzen.

Das erfindungsgemäße Verfahren zur Herstellung einer Verbindung mit einer Platine, mit deren Kontakten Leiter verbunden sind, erfolgt unter Verwendung eines Schutzelements. Die Leiter werden in Ausnehmungen eines mit der Platine verbindbaren, insbesondere mit der Platine verrastbaren Trägers angeordnet, wobei angrenzend an den Träger das Schutzelement angeordnet ist, dessen Ausnehmungen zur Aufnahme der Leiter fluchtend mit den Ausnehmungen des Trägers angeordnet sind und die Leiter durch die fluchtenden Ausnehmungen angeordnet sind. Bevorzugt weist das Schutzelement einen ersten Anschlag auf, der gegen den Träger angeordnet ist, um die Verschwenkung des Schutzelements in einer Richtung auf die Anordnung der Ausnehmungen in einer gemeinsamen Ebene zu beschränken.

Der Träger wird auf der Platine angeordnet, insbesondere auf der Platine verrastet, wobei nach dem oder vor dem Anordnen des Trägers auf der Platine das Schutzelement aus der ersten in die zweite Stellung verschwenkt wird, in welcher die Ebene, in der die Ausnehmungen des Schutzelements angeordnet sind, in einem Winkel, insbesondere von 70° - 120°, insbesondere 90°, zu der Ebene angeordnet sind, in der die Ausnehmungen des Trägers liegen. Dabei werden die Leiter um den Schwenkwinkel gebogen.
Bevorzugt wird ein zweiter Anschlag des Schutzelements beim Verschwenken in die zweite Stellung gegen einen zweiten Anschlag des Trägers angeordnet, der die Verschwenkung auf den Winkel begrenzt.

Optional weist die Platine in dem Bereich, in dem das am Träger angeordnete Schutzelement an die Platine angeordnet wird, zumindest einen, vorzugsweise zwei Vorsprünge auf, die gegen das in die zweite Stellung verschwenkte Schutzelement stoßen und das Schutzelement beim Anordnen des Trägers auf der Platine vom Träger beabstanden, sodass das Schutzelement vom Träger getrennt wird. Auf diese Weise belastet der Vorsprung der Platine das Schutzelement vom Träger weg, beabstandet das Schutzelement vom Träger und schiebt das Schutzelement zumindest abschnittsweise von den Leitern und gibt die Leiter zumindest abschnittsweise, vorzugsweise vollständig frei.

Besonders bevorzugt sind die Vorsprünge über die Platine ragende Kontakte, insbesondere etwa senkrecht zur Platine angeordnete Kontakte.
In einer bevorzugten Ausführungsform weist das Schutzelement in dem Bereich, der in der ersten Stellung dem Träger zugewandt ist, eine Positionierausnehmung auf, in die der Vorsprung, der insbesondere ein senkrecht auf der Platine angeordneter Kontakt ist, ragen kann. Die Positionierausnehmung bzw. die Längsmittelachse der Positionierausnehmung ist parallel zu den Ausnehmungen des Schutzelements angeordnet. Dadurch werden die in den Ausnehmungen angeordneten Leiter bei Anordnung der Positionierausnehmung um Kontakte parallel zu den Kontakten ausgerichtet. Eine Positionierausnehmung des Schutzelements zur Ausnahme eines die Platine überragenden Vorsprungs, der insbesondere ein die Platine überragender Kontakt ist, insbesondere aus den Kontakten besteht, mit denen die Leiter verbunden werden, bildet überdies eine Positionierhilfe zur Positionierung des Schutzelements über den Vorsprung und zur Ausrichtung und Anordnung des am Verbindungselement angeordneten Trägers und der an dem Träger und dem Verbindungselement geführten Leiter.

In Alternative zu einem dem Träger bzw. dessen Positionierausnehmung zugewandten Vorsprung auf der Platine kann das Schutzelement ein Ansatzstück aufweisen, das bei Verschwenken des Schutzelements in die zweite Stellung den Träger auf der Seite überragt,

die dem Schutzelement gegenüber liegt. Ein solches Ansatzstück des Schutzelements ragt vorzugsweise über die Ebene der Fläche, mit der der Träger gegen die Platine angeordnet wird, so dass bei Annähern des Trägers an die Platine das Ansatzstück gegen die Platine stößt und das Schutzelement vom Träger weg belastet und vom Träger beabstandet. Eine Positionierausnehmung, die um einen Vorsprung einer Platine anordnbar ist und/oder ein Ansatzstück, das das Schutzelement (1) auf der Seite überragt, die einer Platine (30) zugewandt ist, dienen dazu, das Schutzelement (1) beim Anordnen gegen die Platine (30) von der Platine (30) und vom Träger (10) zu beabstanden.

Der Träger weist vorzugsweise eine Verrastungseinrichtung zur Verrastung mit der Platine auf seiner ersten Seite auf, die seiner zweiten Seite gegenüber liegt, wobei das Schutzelement in der zweiten Stellung die zweite Seite des Trägers überragt. Bei Anordnen des Trägers mit seiner ersten Seite auf der Platine, insbesondere durch Verrasten mit der Platine, überragt das Schutzelement in der zweiten Stellung die zweite Seite des Trägers und die Platine, wobei die Ausnehmungen des Schutzelements in einem Winkel, insbesondere bevorzugt von 90° zu den Ausnehmungen des Trägers und/oder zur Platine, sodass in den Ausnehmungen des Schutzelements geführte Leiter in diesem Winkel die Platine überragen und bei Anordnung des Trägers in der Nähe der oder angrenzend an die die Platine überragenden Kontakten angeordnet werden. Bevorzugt werden die Ausnehmungen des Schutzelements und entsprechend die darin angeordneten Leiter parallel zu den Kontakten der Platine angeordnet.

Besonders bevorzugt weist der Träger einen Anschlag auf, der auch als dritter Anschlag bezeichnet werden kann, dessen Anordnung gegen einen die Platine überragenden Kontakt in der zweiten Stellung des Schutzelements, bzw. nach Beabstanden des Schutzelements vom Träger zur Anordnung der Leiter, die aus dem Träger ragen, führt, in welcher die Leiter zumindest abschnittsweise parallel zu einem Kontakt sind. Auf diese Weise dient ein solcher Anschlag des Trägers zusätzlich der Positionierung des Trägers und der in dem Träger geführten Leiter angrenzend an Kontakte der Platine und/oder zur Positionierung des Trägers in die zur Verrastung mit der Platine geeignete Stellung. Dieser Anschlag des Trägers kann gleich dem ersten Anschlag des Trägers sein, beispielsweise eine Stirnfläche des Trägers, die eine Ausnehmung begrenzt, in der ein Leiter geführt ist.

Das erfindungsgemäße Schutzelement weist den Vorteil auf, dass während des Verfahrens zur Herstellung die den Träger überragenden Enden der Leiter von den Ausnehmungen des Schutzelements geführt werden, sodass die Abschnitte bzw. Enden der Leiter, die mit den Kontakten der Platine elektrisch verbunden werden, gegen ein Verbiegen aus der Position geschützt sind, in der sie abschnittsweise parallel zum Leiter angeordnet sind.

Insbesondere in der Ausführungsform, in der das Verbindungselement mittels eines Scharnieranteils mit einem Scharnieranteil des Trägers in Kontakt steht, insbesondere mit einem Scharnieranteil des Trägers in Eingriff steht, weist das Schutzelement den Vorteil auf, dass ein Verschwenken um das Scharnier von der ersten in die zweite Stellung alle Leiter, die durchgehend in den Ausnehmungen des Trägers und des Schutzelements angeordnet sind, in eine durch den zweiten Anschlag vorbestimmte Stellung relativ zu den Ausnehmungen des Trägers geführt gebogen werden. Diese Führung des Schutzelements am Träger durch das Scharnier ergibt wegen der Parallelität der Schwenkachse des Scharniers zu der Ebene, in der zumindest zwei Ausnehmungen des Schutzelements, vorzugsweise alle Ausnehmungen des Schutzelements zur Aufnahme von Leiter angeordnet sind, eine parallele Biegung aller in Ausnehmungen des Trägers angeordneten Leiter.

Die Anordnung des Schutzelements angrenzend an den Träger, wobei Leiter in den Ausnehmungen durch Träger und Schutzelement angeordnet werden, ergibt eine für die Montage ausreichend haltbare und reversible Fixierung des Schutzelements angrenzend an den Träger, sodass insbesondere eine einfache Handhabung des in der zweiten Stellung positionierten Schutzelements ohne Beeinträchtigung der Anordnung und Ausrichtung der Leiter erfolgt. Insbesondere erlaubt das Schutzelement ein Herstellungsverfahren, bei dem vor dem Anordnen des Trägers an der Platine und vor dem anschließendem Verbinden der Leiter mit den Kontakten der Platine die Leiter mit endständig angeordnetem Träger und daran angeordnetem Schutzelement, das in der zweiten Stellung gegen den Träger positioniert ist, ein Durchführen der Leiter durch eine Öffnung, insbesondere durch eine Gehäuseöffnung. Entsprechend kann das Herstellungsverfahren den Schritt aufweisen, zumindest einen Leiter mit endständig angeordnetem Schutzelement mit daran angeordnetem Träger durch eine Öffnung eines Gehäuses zu bewegen, wobei jeder Leiter durch eine Ausnehmung des Trägers und eine Ausnehmung des Schutzelements geführt ist, das in die zweite Stellung zum Träger geschwenkt ist, mit anschließendem Anordnen des Trägers auf der Platine und Verbinden des Leiters mit einem auf der Platine angeordneten Kontakt. Vorzugsweise weist das Verfahren das Beabstanden des Schutzelements vom Träger auf, z.B. durch Anordnen des Schutzelements gegen einen Vorsprung der Platine, der insbesondere ein Kontakt ist, oder durch Anordnen eines Vorsprungs des Schutzelements gegen die Platine, wobei das Schutzelement in die zweite Stellung zum Träger geschwenkt ist. In einer alternativen Ausführungsform kann das Schutzelement durch die aneinander angeordneten Scharnieranteile am Träger angeordnet bleiben, wenn die Leiter mit den Kontakten verbunden sind und z.B. Durchbrechungen aufweisen, in die eine Einrichtung zum Verbinden eines Leiters mit einem Kontakt treten kann.

Optional kann das Schutzelement Durchbrechungen aufweisen, die den Eintritt einer Einrichtung zum Verbinden eines Leiters mit einem Kontakt erlaubt, z.B. zwei einander gegenüberliegende Durchbrechungen in der Wandung einer Ausnehmung des Schutzelements, durch die z.B. jeweils eine Elektrode eines Paars Schweißelektroden treten kann, die Teil der Einrichtung zum Verbinden sind. In dieser Ausführungsform bleibt das Schutzelement an den Leitern angeordnet und bildet einen Bestandteil des mit dem Verfahren hergestellten Produkts. Dabei kann das Schutzelement optional den Träger kontaktieren, z.B. können die Scharnieranteile des Schutzelements mit den Scharnieranteilen des Trägers in Kontakt stehen, oder das Schutzelement kann um einen Abstand vom Träger beabstandet sein, z.B. um einen Abstand, der kürzer ist als der Abschnitt der Leiter, der von den Ausnehmungen des Schutzelements umfasst ist.

Die Leiter können z.B. massive Leiter, kompaktierte Litzenleiter und/oder von einer Hülse umfasste, insbesondere mit einer Hülse verpresste Leiter oder mit Lot verfestigte Leiter sein.

### Genaue Beschreibung der Erfindung

Die Erfindung wird nun genauer mit Bezug auf die Figuren beschrieben, die schematisch
- in Figur 1 ein Schutzelement in Aufsicht,
- in Figur 2 ein Schutzelement nach Figur 1 im Schnitt,
- in Figur 3 ein Schutzelement mit daran angeordnetem Träger in Aufsicht,
- in Figur 4 ein an einem Träger angeordnetes Schutzelement im Schnitt,
- in Figur 5 ein an einem Träger angeordnetes Schutzelement mit Leitern in Aufsicht,
- in Figur 6 ein an einem Träger angeordnetes Schutzelement mit Leiter nach Figur 5 im Schnitt,
- in Figur 7 ein an einem Träger angeordnetes Schutzelement in der zweiten Stellung mit Leitern in Aufsicht und
- in Figur 8 ein an einem Träger in die zweite Stellung geschwenktes Schutzelement mit Leiter nach Figur 7 im Schnitt,
- in Figur 9 ein an einem Träger in die zweite Stellung geschwenktes Schutzelement mit einem Leiter vor Verrastung des Trägers an einer Platine im Schnitt und
- in Figur 10 ein vom Träger beabstandetes Schutzelement mit Leiter bei Verrastung des Trägers mit der Platine im Schnitt zeigen.

In den Figuren bezeichnen gleiche Bezugsziffern funktionsgleiche Elemente.

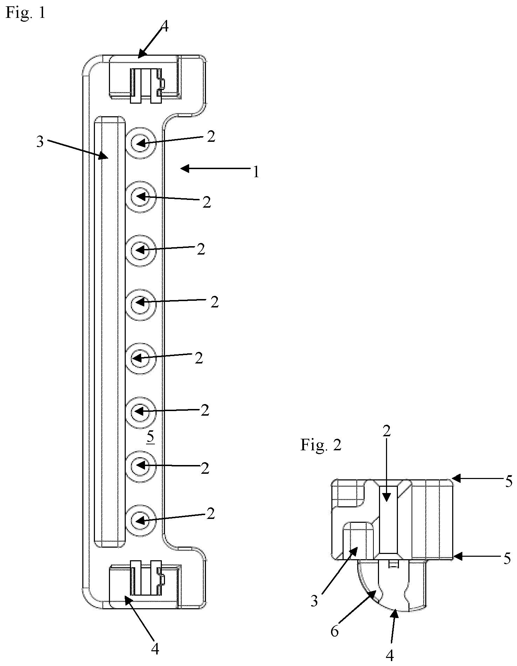

Figur 1 zeigt in der Aufsicht auf ein Schutzelement 1 acht Ausnehmungen 2, die entsprechend der generell bevorzugten Ausführungsform in einer gemeinsamen Ebene liegen und zueinander parallel verlaufen. Das Schutzelement 1 weist eine Positionierausnehmung 3 auf, die gegen einen Vorsprung einer Platine angeordnet wird. Entsprechend der generell bevorzugten Ausführung besteht der Vorsprung aus den die Platine überragenden Kontakten. Das Schutzelement 1 weist zwei beabstandete Scharnieranteile 4 auf, die mit passenden Scharnieranteilen eines Trägers ein Scharnier bilden, dessen Schwenkachse parallel zu der Ebene liegt, in der die Ausnehmungen 2 zur Aufnahme einzelner Leiter 20 angeordnet sind.

Wie aus Figur 2, die einen Schnitt durch ein Schutzelement 1 nach Figur 1 zeigt ersichtlich ist, kann das Schutzelement 1 durch zwei Flächen in parallelen Ebenen 5 begrenzt sein, bzw. sich zwischen zwei parallelen Ebenen 5 erstrecken. Die Ausnehmungen 2, die vorzugsweise vollständig durch das Schutzelement 1 verlaufen und zu beiden Ebenen 5 offen sind, sind vorzugsweise parallel zur Positionierausnehmung 3 angeordnet. Das Scharnierteil 4 kann wahlweise eine Ebene 5 des Schutzelements 1 überragen. Das Scharnierteil 4 kann z.B. eine Führungsfläche 6 aufweisen, die gegen eine passende bzw. komplementäre Führungsfläche eines Trägers 10 in einem Bogen beweglich ist und eine Führung für die Verschwenkung des Schutzelements 1 gegen den Träger 10 bildet.

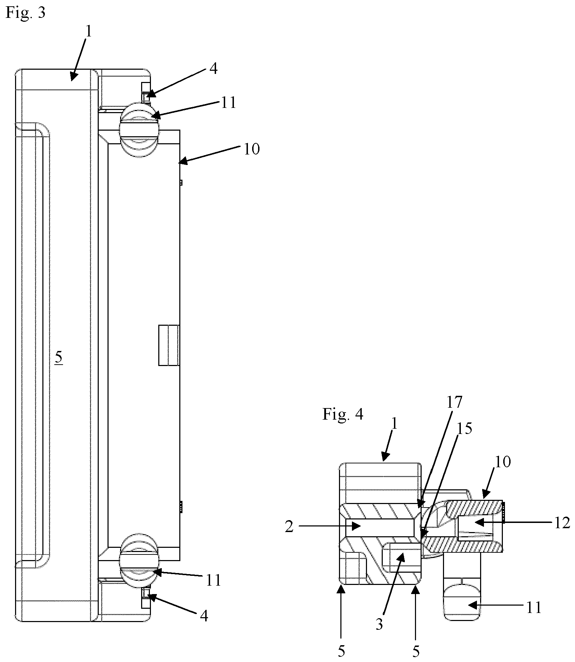

Figur 3 zeigt in Aufsicht ein Schutzelement 1, das an einem Träger 10 angeordnet ist und in der ersten Stellung positioniert ist. Das Schutzelement 1 ist dadurch geführt am Träger 10 schwenkbar, dass sein Scharnierteil 4 gegen einen passenden bzw. komplementären Scharnierteil des Trägers 10 angeordnet ist. Der Träger 10 weist zwei Verrastungselemente 11 auf, mit denen der Träger 10 mit passenden Verrastungselementen 33 einer Platine 30 verrastbar ist. Vorliegend ist als Verrastungselement 11 des Trägers 10 ein reversibel verformbares Element gezeigt, das mit einem Verrastungselement 33 als passendem Gegenstück verrastbar ist, das auf der Platine 30 befestigt ist, beispielsweise einer Bohrung.

Figur 4 zeigt einen Schnitt durch ein Schutzelement 1 und einen Träger 10 von Figur 3 in der ersten Stellung, in der die Ausnehmungen 2 des Schutzelements 1 fluchtend mit jeweils einer Ausnehmung 12 des Trägers 10 angeordnet sind. Der erste Anschlag 15 des Schutzelements 1 liegt gegen den Träger 10 an und begrenzt die Verschwenkung des Schutzelements 1 gegen den Träger 10 auf die erste Stellung. Der zweite Anschlag 17 begrenzt die Verschwenkung des Schutzelements 1 in die zweite Stellung durch Kontaktieren des Trägers 10.

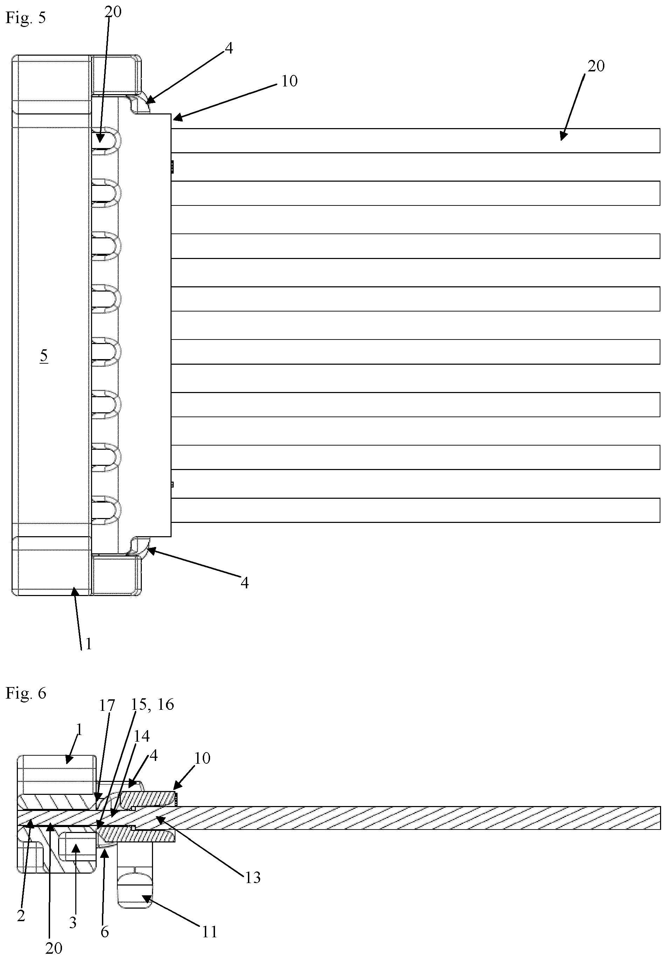

Figur 5 zeigt in der Aufsicht, dass in einer Ausnehmung 2 des Trägers ein Leiter 2 angeordnet sein kann, der durch eine Ausnehmung 12 des Trägers 10 geführt ist. Durch die parallele Anordnung der Ausnehmungen 12 im Träger 10 in einer gemeinsamen Ebene und die parallele Anordnung der Ausnehmungen 2 des Schutzelements 1 sind in der hier gezeigten ersten Stellung, in der die Ausnehmungen 2, 12 von Schutzelement 1 und Träger 10 fluchtend ausgerichtet sind, die Leiter 20 in einer gemeinsamen Ebene und parallel zueinander bzw. gradlinig angeordnet. Vorzugsweise weist die Ausnehmung 12 des Trägers 10 einen ersten Abschnitt 13 mit einem Durchmesser auf, der zumindest dem Außendurchmesser der umfänglichen Isolierung eines Leiters 20 entspricht und einen angrenzenden zweiten Abschnitt 14 mit einem kleineren Durchmesser, der nur den abisolierten Leiter 20 aufnimmt. Dadurch wird zwischen dem ersten Abschnitt 13 und dem zweiten Abschnitt 14 eine Verjüngung der Ausnehmung 12 des Trägers 10 gebildet, gegen welche die Stirnfläche der Isolierung des Leiters 20 stoßen kann, während nur der abisolierte endständige Abschnitt des Leiters 20 durch den zweiten Abschnitt 14 in die Ausnehmung 2 des Schutzelements 1 angeordnet werden kann.

Figur 6 zeigt einen Schnitt durch ein Schutzelement 1, das entsprechend Figur 5 in der ersten Stellung an einem Träger 10 positioniert ist, wobei ein Leiter 20 durch die Ausnehmung 12 des Trägers 10 und die fluchtend angeordnete Ausnehmung 2 des Schutzelements 1 angeordnet ist.

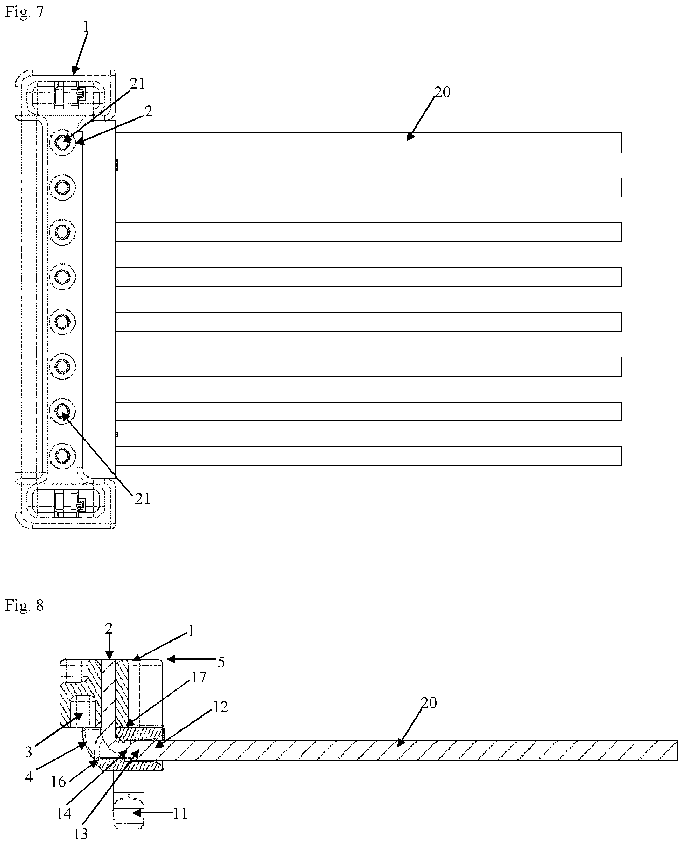

Figur 7 zeigt in Aufsicht das in die zweite Stellung geschwenkte Schutzelement 1, vorliegend in etwa 90° zur ersten Stellung. Entsprechend sind die Leiter 20 von der Ebene, in der die Ausnehmungen 12 des Trägers 10 angeordnet sind, in die um etwa 90° geschwenkte zweite Position der Ausnehmungen 2 des Schutzelements 1 gebogen. Entsprechend zeigt die Aufsicht von Figur 7 die Stirnflächen 21 der Leiter 20 mit den Ausnehmungen 2 des Schutzelements 1.

Figur 8 zeigt im Schnitt das in die zweite Position geschwenkte Schutzelement 1 am Träger 10, wobei der Leiter 20 durch die Verschwenkung des Schutzelements 1 gegen die Ebene der Ausnehmungen 12 des Trägers 10 gebogen ist. In dieser Ansicht wird deutlich, dass der Leiter 20 durch die bevorzugte parallele Anordnung der Ausnehmungen 2 des Schutzelements 1 und der Positionierausnehmung 3 parallel zur Positionierausnehmung 3 angeordnet wird. Der zweite Anschlag 17 liegt gegen den Träger 10 und begrenzt die Verschwenkung des Schutzelements 1 bis in die zweite Stellung. Ein Teil der Stirnfläche des Trägers, z.B. in dem Bereich, der seine Ausnehmungen 12 umgibt, kann einen dritten Anschlag 16 bilden, der bei Anordnung des mit dem Schutzelement 1 verbundenen Trägers 10 gegen den Kontakt 31 stößt.

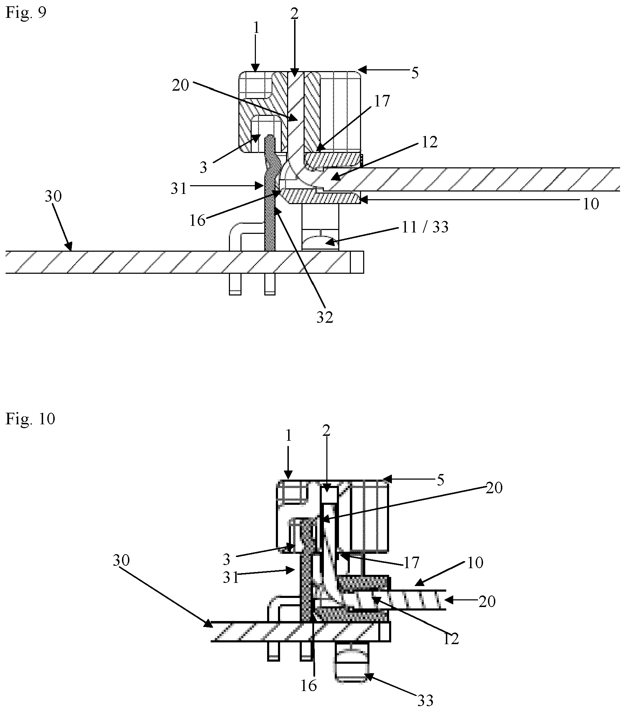

Figur 9 zeigt für das Herstellungsverfahren einen ersten Teilschritt der Anordnung des in die zweite Position zum Träger 10 verschwenkten Schutzelements 1 in Richtung auf eine Platine 30, die von einem etwa senkrecht angeordneten Kontakt 31 überragt wird. Entsprechend der generell bevorzugten Ausführungsform wird das Schutzelement 1 mit seiner Positionierausnehmung 3 gegen den Kontakt 31 angeordnet, der einen Vorsprung auf der Platine bildet, und der Träger 10 weist einen dritten Anschlag 16 auf, der gegen die Verbindungsfläche 32 des Kontakts 31 stößt, mit der der parallele Abschnitt des Leiters 20 verbunden wird. In der in Figur 9 gezeigten Position ist der Träger 10 noch vom Verrastungselement 33 der Platine 30 beabstandet. Beim Bewegen des Trägers 10 gegen die Platine, bzw. gegen deren Verrastungselement 33 verrastet der Träger 10 mit der Platine 30. Die Bewegung des mit dem Träger 10 verbundenen Schutzelements 1 gegen den Kontakt 31 wird das Schutzelement 1 vom Träger 10 weg belastet und beabstandet. Da der Abschnitt des Leiters 20, der in der Ausnehmung 2 des Schutzelements 1 angeordnet ist, parallel zur Bewegungsrichtung des Schutzelements 1 vom Träger 10 und parallel zur Längsmittelachse der Positioniereinrichtung 3 liegt, rutscht das Schutzelement 1 vom Endabschnitt des Leiters 20.

Wahlweise kann generell die Positionierausnehmung 3 so gestaltet sein, dass die Länge des Kontakts 31, der die Platine 30 überragt, das Schutzelement 1 um den Abstand von Träger 10 beabstandet, der gleich der Länge des Leiters 20 in der Ausnehmung 2 des Schutzelements 1 ist, um das Schutzelement 1 vollständig vom Leiter 20 zu entfernen.

Figur 10 zeigt, dass das Schutzelement 1 geeignet ist, den Endabschnitt des Leiters 20 geführt parallel zu einem Kontakt 31, der eine Platine 30 überragt, zu positionieren und gegen mechanische Belastungen zu schützen. Auf diese Weise wird eine für die spätere Verbindung des Leiters 20 mit dem Kontakt 31 geeignete Position sichergestellt.

Bevorzugt wird im Anschluss an die in Figur 10 gezeigte Beabstandung des Schutzelements 1 vom Träger 10 das Schutzelement 1 vollständig vom Leiter 20 entfernt und Leiter 20 wird mit dem Kontakt 31 verbunden, beispielsweise durch eine Schweißung.

### Bezugszeichenliste:

1 Schutzelement
2 Ausnehmung des Schutzelements
3 Positionierausnehmung
4 Scharnieranteil
5 Ebene
6 Führungsfläche
10 Träger
11 Verrastungselement
12 Ausnehmung des Trägers
13 erster Abschnitt
14 zweiter Abschnitt
15 erster Anschlag
16 dritter Anschlag
17 zweiter Anschlag
20 Leiter
21 Stirnfläche
30 Platine
31 Kontakt
32 Verbindungsfläche
33 Verrastungselement der Platine

## Patentansprüche

1. Träger (10) mit Schutzelement (1) für elektrische Leiter, wobei das Schutzelement (1) Ausnehmungen (2) zur Aufnahme einzelner Leiter (20) und einen Scharnieranteil (4) aufweist, der gegen einen passenden Scharnieranteil eines Trägers (10) angeordnet und eingerichtet ist, mit dem Scharnieranteil des Trägers (10) ein Scharnier zu bilden, das eine Schwenkachse aufweist, die parallel zu der Ebene liegt, in der die Ausnehmungen (2) des Schutzelements (1) angeordnet sind und wobei der Träger (10) in einer Ebene angeordnete Ausnehmungen (12) zur Aufnahme der einzelnen Leiter (20) aufweist, die parallel zur Schwenkachse des von den Scharnieranteilen gebildeten Scharniers liegt, wobei das Schutzelement (1) einen ersten Anschlag aufweist, der die Verschwenkung des Schutzelements (1) um die Schwenkachse gegen den Träger (10) in eine erste Stellung begrenzt, in der die Ausnehmungen (2) des Schutzelements (1) fluchtend mit den Ausnehmungen (12) des Trägers (10) ausgerichtet sind und das Schutzelement (1) einen zweiten Anschlag (17) aufweist, der eingerichtet ist, die Verschwenkung des Schutzelements (1) gegen den Träger (10) in eine zweite Stellung zu beschränken, in der die Ausnehmungen (2) des Schutzelements (1) in einem Winkel von 70° bis 120° gegen die Ausnehmungen (12) des Trägers (10) verschwenkt sind, **dadurch gekennzeichnet, dass** das Schutzelement (1) eine Positionierausnehmung (3) aufweist, deren Längsachse parallel zur Längsachse der Ausnehmungen (2) des Schutzelements (1) liegt und die um einen Vorsprung einer Platine (30) anordenbar ist, um das Schutzelement (1) beim Anordnen des Trägers (10) gegen eine Platine (30) von der Platine (30) und vom Träger (10) zu beabstanden, und/oder das Schutzelement (1) zumindest ein
Ansatzstück aufweist, das bei Verschwenken des Schutzelements (1) in die zweite Stellung den Träger (10) auf der Seite überragt, die dem Schutzelement (1) gegenüber liegt, um das Schutzelement (1) beim Anordnen des Trägers (10) gegen eine Platine (30) von der Platine (30) und vom Träger (10) zu beabstanden.

2. Verfahren zur Herstellung einer Vorrichtung, die mit Kontakten (31), die auf einer Platine (30) festgelegt sind, elektrisch verbundene Leiter (10) aufweist, die in Ausnehmungen (12) eines mit der Platine (30) verbundenen Trägers (10) angeordnet sind, mit den Schritten des Bereitstellens der Kontakte (31), die auf der Platine (30) festgelegt sind und des Verbindens einzelner Leiter (10) mit einzelnen Kontakten (31), bei welchem das Anordnen einzelner Leiter (10) an Kontakte (31) die Schritte aufweist:
- Anordnen einzelner Leiter (20) in Ausnehmungen (12) eines Trägers (10) und in Ausnehmungen (2) eines Schutzelements (1), das zumindest einen Scharnieranteil (4) aufweist, der gegen einen passenden Scharnieranteil des Trägers (10) geführt ist und eine Schwenkachse bildet, die parallel zu der Ebene liegt, in der die Ausnehmungen (2) des Schutzelements (1) und/oder die Ausnehmungen (12) des Trägers (10) angeordnet sind, wobei die Leiter (10) in einer ersten Stellung, in der die Ausnehmungen (12) des Trägers (10) fluchtend und in einer gemeinsamen Ebene mit den Ausnehmungen (2) des Schutzelements (1) ausgerichtet sind, in die Ausnehmungen (12,2) des Trägers (10) und des Schutzelements (1) angeordnet werden und anschließend das Schutzelement (1) in einen Winkel gegen den Träger (10) verschwenkt wird, so dass die Ebene, in der die Ausnehmungen (2) des Schutzelements (1) angeordnet sind, gegen die Ebene in einem Winkel geneigt ist, in der die Ausnehmungen (12) des Trägers (10) angeordnet sind, und
- Anordnen des Trägers (10) an die Platine (30),
**gekennzeichnet durch** den Verfahrensschritt
- Beabstanden des Schutzelements (1) vom Träger (10).

3. Verfahren nach Anspruch 2, **dadurch gekennzeichnet, dass** das Schutzelement (1) einen ersten Anschlag aufweist, der die Verschwenkung des Schutzelements (1) gegen den Träger (10) in eine erste Stellung begrenzt, in der die Ausnehmungen (2) des Schutzelements (1) in einer gemeinsamen Ebene mit den Ausnehmungen (12) des Trägers (10) angeordnet sind und das Schutzelement (1) einen zweiten Anschlag (17) aufweist, der die Verschwenkung des Schutzelements (1) gegen den Träger (10) in eine zweite Stellung begrenzt, in der die Ausnehmungen (2) des Schutzelements (1) in einem vorgegebenen Winkel gegen die Ebene verschwenkt sind, in der die Ausnehmungen (12) des Trägers (10) angeordnet sind.

4. Verfahren nach Anspruch 2 oder 3, **dadurch gekennzeichnet, dass** das Schutzelement (1) auf der Seite, die in der ersten Stellung dem Träger (10) zugewandt ist, eine Positionierausnehmung (3) aufweist, deren Längsmittelachse parallel zur Ebene der Ausnehmungen (2) des Schutzelements (1) liegt und die beim Anordnen des Trägers (10) an die Platine (30) gegen die Kontakte (31) angeordnet wird.

5. Verfahren nach einem der Ansprüche 2 bis 4, **dadurch gekennzeichnet, dass** der Träger (10) einen Anschlag aufweist, der in der zweiten Stellung des Schutzelements (1) beim Anordnen des Trägers (10) an die Platine (30) gegen die Verbindungsfläche (32) des Kontakts (31) stößt, die mit dem Leiter (10) verbunden wird.

6. Verfahren nach Anspruch 4 oder nach Ansprüchen 4 und 5 zusammen, **dadurch gekennzeichnet, dass** die Positionierausnehmung (3) gegen einen Kontakt (31) angeordnet wird und der Träger (10) durch Bewegen gegen die Platine (30) mit der Platine (30) verbunden wird, während der gegen die Positionierung (3) angeordnete Kontakt (3) das Schutzelement (1) vom Träger (10) beabstandet.

7. Verfahren nach einem der Ansprüche 2 bis 6, **dadurch gekennzeichnet, dass** das Schutzelement (1) vor dem Verbinden von Leitern (10) mit Kontakten (1) von den Leitern (10) entfernt wird.

## Claims

1. A carrier (10) with protective element (1) for electrical conductors, wherein the protective element (1) has recesses (2) for receiving individual conductors (20) and a hinge part (4), which is arranged and configured against a matching hinge part of a carrier (10), to form a hinge with the hinge part of the carrier (10), which has a pivot axis, which lies parallel to the plane, in which the recesses (2) of the protective element (1) are arranged and wherein the carrier (10) has recesses (12) arranged in a plane for receiving the individual conductors (20), which lies parallel to the pivot axis of the hinge formed by the hinge parts, wherein the protective element (1) has a first stop, which limits the pivoting of the protective element (1) about the pivot axis against the carrier (10) in a first position, in which the recesses (2) of the protective element (1) are aligned flush with the recesses (12) of the carrier (10) and the protective element (1) has a second stop (17), which is configured to limit the pivoting of the protective element (1) against the carrier (10) in a second position, in which the recesses (2) of the protective element (1) are pivoted at an angle of 70° to 120° against the recesses (12) of the carrier (10), **characterized in that** the protective element (1) has a positioning recess (3), the longitudinal axis of which lies parallel to the longitudinal axis of the recesses (2) of the protective element (1) and which can be arranged around a projection of a circuit board (30), in order to space the protective element (1) apart from the circuit board (30) and from the carrier (10) when arranging the carrier (10) against a circuit board (30), and/or the protective element (1) has at least one extension piece, which when the protective element (1) pivots into the second position projects beyond the carrier(10) on the side, which is opposite the protective element (1), in order to space the protective element (1) apart from the circuit board (30) and from the carrier (10) when arranging the carrier (10) against the circuit board (30).

2. A method for producing a device, which has conductors (20) electrically connected with contacts (31), which are fixed on a circuit board (30), which conductors are arranged in recesses (12) of a carrier (10) connected with the circuit board (30), with the steps of the provision of the contacts (31), which are fixed on the circuit board (30) and of the connection of individual conductors (20) with individual contacts (31), in which the arranging of individual conductors (20) on contacts (31) has the steps:
- Arranging individual conductors (20) in recesses (12) of a carrier (10) and in recesses (2) of a protective element (1), which has at least one hinge part (4), which is guided against a matching hinge part of the carrier (10) and forms a pivot axis, which lies parallel to the plane, in which the recesses (2) of the protective element (1) and/or the recesses (12) of the carrier (10) are arranged, wherein the conductors (20) in a first position, in which the recesses (12) of the carrier (10) are aligned flush and in a common plane with the recesses (2) of the protective element (1), in which recesses (12, 2) of the carrier (10) and of the protective element (1) are arranged and then the protective element (1) is pivoted at an angle against the carrier (10), so that the plane, in which the recesses (2) of the protective element (1) are arranged, is inclined against the plane at an angle, in which the recesses (12) of the carrier (10) are arranged, and
- arranging the carrier (10) on the circuit board (30),
**characterized by** the method step
- spacing the protective element (1) apart from the carrier (10).

3. A method according to Claim 2, **characterized in that** the protective element (1) has a first stop, which limits the pivoting of the protective element (1) against the carrier (10) in a first position, in which the recesses (2) of the protective element (1) are arranged in a common plane with the recesses (12) of the carrier (10) and the protective element (1) has a second stop (17), which limits the pivoting of the protective element (1) against the carrier (10) in a second position, in which the recesses (2) of the protective element (1) are pivoted at a predetermined angle against the plane, in which the recesses (12) of the carrier (10) are arranged.

4. A method according to Claim 2 or 3, **characterized in that** the protective element (1) on the side, which in the first position is facing the carrier (10) has a positioning recess (3), the longitudinal central axis of which lies parallel to the plane of the recesses (2) of the protective element (1) and which is arranged against the contacts (31) when arranging the carrier (10) on the circuit board (30).

5. A method according to any one of Claims 2 to 4, **characterized in that** he carrier (10) has a stop, which in the second position of the protective element (1) when arranging the carrier (10) on the circuit board (30) abuts against the connecting surface (32) of the contact (31), which is connected with the conductor (20).

6. A method according to Claim 4 or according to Claims 4 and 5 together, **characterized in that** the positioning recess (3) is arranged against a contact (31) and the carrier (10) is connected with the circuit board (30) by moving against the circuit board (30), while the contact (3) arranged against the positioning recess (3) spaces the protective element (1) apart from the carrier (10).

7. A method according to any one of Claims 2 to 6, **characterized in that** the protective element (1) is removed from the conductors (20) before connecting the conductors (20) with contacts (1).

## Revendications

1. Support (10) avec élément de protection (1) pour des conducteurs électriques, l'élément de protection (1) comprenant des évidements (2) pour le logement de conducteurs individuels (20) et une partie de charnière (4), qui est disposé contre une partie de charnier correspondante d'un support (10) et qui est conçue pour former, avec la partie de charnière du support (10), une charnière, qui comprend un axe de pivotement, qui est parallèle au plan, dans lequel les évidements (2) de l'élément de protection (1) sont disposés, et le support (10) comprenant des évidements (12) disposés dans un plan pour le logement des conducteurs individuels (20), qui est parallèle à l'axe de pivotement de la charnière formée par les parties de charnière, l'élément de protection (1) comprenant une première butée, qui limite le pivotement de l'élément de protection (1) autour de l'axe de pivotement par rapport au support (10) vers une première position, dans laquelle les évidements (2) de l'élément de protection (1) sont alignés avec les évidements (12) du support (2) du support (10) et l'élément de protection (1) comprenant une deuxième butée (17) qui est conçue pour limiter le pivotement de l'élément de protection (1) par rapport au support (10) vers une deuxième position, dans laquelle les évidements (2) de l'élément de protection (1) sont pivotés à un angle de 70° à 120° par rapport aux évidements (12) du support (10), **caractérisé en ce que** l'élément de protection (1) comprend un évidement de positionnement (3) dont l'axe longitudinal est parallèle à l'axe longitudinal des évidements (2) de l'élément de protection (1) et qui peut être disposé autour d'une saillie d'une platine (30), afin d'écarter l'élément de protection (1) de la platine (30) et du support (10) lors de la disposition du support (10) contre une platine (30) et/ou l'élément de protection (1) comprenant au moins une pièce rapportée qui dépasse, lors du pivotement de l'élément de protection (1) vers la deuxième position, du support (10) sur le côté qui fait face à l'élément de protection (1), afin d'écarter l'élément de protection (1) de la platine (30) et du support (10) lors de la disposition du support (10) contre une platine (30).

2. Procédé de fabrication d'un dispositif qui est comprend des conducteurs (10) reliés électriquement avec des contacts (31) qui sont fixés sur une platine (30), qui sont disposés dans des évidements (12) d'un support (10) relié avec la platine (30), avec les étapes de mise à disposition des contacts (31), qui sont fixés sur la platine (30) et de liaison des conducteurs individuels (10) avec différents contacts (31), dans lequel la disposition des conducteurs individuels (10) sur les contacts (31) comprend les étapes :
- disposition de conducteurs individuels (20) dans des évidements (12) d'un support (10) et dans des évidements (2) d'un élément de protection (1), qui comprend au moins une partie de charnière (4), qui est guidée par rapport à une partie de charnière correspondante du support (10) et forme un axe de pivotement qui est parallèle au plan dans lequel les évidements (2) de l'élément de protection (1) et/ou les évidements (12) du support (10) sont disposés, les conducteurs (10) étant disposés dans une première position, dans laquelle les évidements (12) du support (10) sont alignés et sont disposés dans un plan commun avec les évidements (2) de l'élément de protection (1), dans les évidements (12, 2) du support (10) et de l'élément de protection (1) puis l'élément de protection (1) est pivoté à un angle par rapport au support (10) de façon à ce que le plan dans lequel les évidements (2) de l'élément de protection (1) sont disposés, soit incliné avec un angle par rapport au plan dans lequel les évidements (12) du support (10) sont disposés et
- disposition du support (10) sur la platine (30),
**caractérisé par** l'étape de procédé :
- écartement de l'élément de protection (1) du support (10).

3. Procédé selon la revendication 2, **caractérisé en ce que** l'élément de protection (1) comprend une première butée, qui limite le pivotement de l'élément de protection (1) par rapport au support (10) vers une première position dans laquelle les évidements (2) de l'élément de protection (1) sont disposés dans un plan commun avec les évidements (12) du support (10) et l'élément de protection (1) comprend une deuxième butée (17) qui limite le pivotement de l'élément de protection (1) par rapport au support (10) vers une deuxième position dans laquelle les évidements (2) de l'élément de protection (1) sont pivotés à un angle prédéterminé par rapport au plan dans lequel les évidements (12) du support (10) sont disposés.

4. Procédé selon la revendication 2 ou 3, **caractérisé en ce que** l'élément de protection (1) comprend, sur le côté orienté vers le support (10) dans la première position, un évidement de positionnement (3) dont l'axe longitudinal est parallèle au plan des évidements (2) de l'élément de protection (1) et qui est disposé contre les contacts (31) lors de la disposition du support (10) sur la platine (30).

5. Procédé selon l'une des revendications 2 à 4, **caractérisé en ce que** le support (10) comprend une butée qui bute, dans la deuxième position de l'élément de protection (1), lors de la disposition du support (10) sur la platine (30), contre la surface de liaison (32) du contact (31), qui est reliée au conducteur (10).

6. Procédé selon la revendication 4 ou selon les revendications 4 et 5 ensemble, **caractérisé en ce que** l'évidement de positionnement (3) est disposé contre un contact (31) et le support (10) est relié avec la platine (30) par un mouvement par rapport à la platine (30), tandis que le contact (3) disposé contre l'évidement de positionnement (3) écarte l'élément de protection (1) du support (10).

7. Procédé selon l'une des revendications 2 à 6, **caractérisé en ce que** l'élément de protection (1) est éliminé des conducteurs (10) avant la liaison des conducteurs (10) avec les contacts (1).
